# EUROPÄISCHE PATENTSCHRIFT

(11) **EP 2 132 358 B1**
(45) Veröffentlichungstag und Bekanntmachung des Hinweises auf die Patenterteilung: **01.01.2014**
(21) Anmeldenummer: 08733224.3
(22) Anmeldetag: 31.03.2008
(51) Int. Cl.: C23C 16/30, C23C 30/00

(54) **MEHRLAGIGE CVD-SCHICHT**
MULTILAYER CVD COATING
COUCHE CVD MULTICOUCHE

(30) Priorität: 02.04.2007 AT 21207 U
(43) Veröffentlichungstag der Anmeldung: 16.12.2009
(73) Patentinhaber: Ceratizit Austria Gesellschaft M.B.H., 6600 Reutte (AT)
(72) Erfinder: KATHREIN, Martin, A-6600 Reutte (AT)
(86) Internationale Anmeldenummer: PCT/AT2008/000118
(87) Internationale Veröffentlichungsnummer: WO 2008/119095

(56) Entgegenhaltungen:
- EP-A- 0 306 077
- EP-A- 1 473 101
- AT-U1- 8 346
- STOIBER M ET AL: "PACVD TiN/Ti-B-N multilayers: from micro- to nano-scale" COMPUTATIONAL LINGUISTICS AND INTELLIGENT TEXT PROCESSING. 5TH INTERNATIONAL CONFERENCE, CICLING 2004. PROCEEDINGS (LECTURE NOTES IN COMPUT. SCI. VOL.2945) SPRINGER-VERLAG BERLIN, GERMANY, 2004, Seiten 348-354, XP002489375 ISBN: 3-540-21006-7
- JAYARAMAN ET AL: "HfB2 and Hf-B-N hard coatings by chemical vapor deposition" SURFACE AND COATINGS TECHNOLOGY, ELSEVIER, AMSTERDAM, NL, Bd. 200, Nr. 22-23, 20. Juni 2006 (2006-06-20), Seiten 6629-6633, XP005422360 ISSN: 0257-8972
- HOLZSCHUH H: "Deposition of Ti-B-N (single and multilayer) and Zr-B-N coatings by chemical vapor deposition techniques on cutting tools" THIN SOLID FILMS, ELSEVIER-SEQUOIA S.A. LAUSANNE, CH, Bd. 469-470, 22. Dezember 2004 (2004-12-22), Seiten 92-98, XP004663293 ISSN: 0040-6090

## Beschreibung

Die Erfindung betrifft eine mehrlagige CVD-Schicht mit einer Dicke von 0,5 µm bis 16 µm und ein Werkzeug, das mit einer solchen Schicht versehen ist.

Zur Erhöhung der Verschleißbeständigkeit werden auf verschleißbeanspruchten Werkzeugen, insbesondere auf Schneidwerkzeugen und Verschleißteilen, mittels physikalischer oder chemischer Schichtabscheidung aus der Dampf- bzw. Gasphase hoch verschleißfeste Hartstoffschichten aufgebracht. Diese Schichten weisen Härtewerte üblicherweise im Bereich von 15 bis 40 GPa auf. Verschleißbeständige Hartstoffschichten werden im Regelfall auf verschleißbeständigen Substratwerkstoffen abgeschieden. Zu der Gruppe der verschleißbeständigen Werkstoffe für Substratkörper zählen Hartmetalle, Cermets, Hartstoffe und Werkzeugstähle, um die wichtigsten Vertreter zu nennen. Unter Hartmetall versteht man dabei einen Verbundwerkstoff, der aus einer karbidischen Hartstoffphase und einem metallischen Binder, bevorzugt Kobalt, aufgebaut ist. Die Werkstoffgruppe der Cermet-Werkstoffe umfasst alle Werkstoffe, die aus einer oder mehreren keramischen Phasen und aus einer oder mehreren metallischen Phasen aufgebaut sind. Unter Hartstoffen werden alle Stoffe mit einer Härte von > 10 GPa zusammengefasst. Werkzeugstähle sind nach DIN 17300 Stähle, die durch ihre Anwendung in Werkzeugen definiert sind.

Grundsätzlich werden zwei Beschichtungsverfahren zur Abscheidung von Hartstoffschichten aus der Dampf- bzw. Gasphase unterschieden, nämlich Physical Vapour Deposition (PVD) und Chemical Vapour Deposition (CVD). Weiters gibt es dazu eine Vielzahl von Verfahrensvarianten. Beispielsweise wird beim PVD-Verfahren zwischen den Abstäubemethoden, wie atomarem Teilchenbeschuss des Targetmaterials (Sputter-Prozess) und Materialabtrag des Targets durch Lichtbogen- bzw. Funkenerosion unterschieden. Chemische Aufdampfverfahren können beispielsweise auch Plasma-unterstützt (plasma assisted, PA-CVD-Verfahren) durchgeführt werden. CVD-Schichten weisen im Vergleich zu PVD-Schichten eine gröbere, stengelförmige Kristallstruktur auf.

Mittels physikalischer oder chemischer Schichtabscheidung können verschleißfeste Hartstoffschichten aus Karbiden, Nitriden, Boriden, Siliziden und Oxiden auf geeigneten Substratkörpern hergestellt werden. Physikalische Abscheideprozesse ermöglichen eine breite Auswahl der chemischen Zusammensetzungen der Hartstoffschichten. Eine gleichmäßige Beschichtung von Körpern mit komplexen geometrischen Formen ist schwierig und aufwändig. Prozesstemperaturen, die im Allgemeinen unterhalb von 500°C liegen, erlauben aber den Einsatz von beweglichen Halterungssystemen für die zu beschichtenden Werkzeuge.

Das thermisch aktivierte CVD-Verfahren zeigt eigenständige charakteristische Verfahrensmerkmale, die vorwiegend durch die hohen Abscheidetemperaturen geprägt sind. Die Schichtabscheidetemperaturen von thermisch aktivierten CVD-Verfahren zur Herstellung von Hartstoffschichten liegen über 500°C. Ein Bewegungsablauf der Substrate im Beschichtungsprozess ist technisch schwer realisierbar. Von den mittels CVD-Verfahren hergestellten Hartstoffschichten haben sich bevorzugt Karbide und Nitride sowie Karbonitride und Oxynitride der Elemente der Gruppe Ti, Zr und Hf, insbesondere aber des Titans als besonders günstig herausgestellt und werden verbreitet zur Verlängerung der Gebrauchsdauer von Werkzeugen, insbesondere von Zerspanungswerkzeugen eingesetzt. Diese werden oft in ein- oder mehrlagiger Ausführung und auch in Kombination mit Aluminiumoxid angewendet. Ein wichtiges charakteristisches Merkmal von CVD-Schichten sind die ausgeprägten kristallinen Strukturen, die oft Vorzugstexturen zeigen. Daraus resultiert generell auch eine raue Oberflächenstruktur, welche durch eine Nachbehandlung mit geeigneten Glättungsverfahren eingeebnet wird.

Um die Schichthärte zu steigern, werden auch B-haltige Hartstoffschichten eingesetzt.

So ist in der EP 0 306 077 eine PVD oder CVD-Metall-Bornitrid-Schicht beschrieben, die einen B-Gehalt von 1 bis 20 At.% aufweist und einphasig vorliegt. Die Schicht kann auch mehrlagig ausgeführt sein, wobei die Bornitrid-Schichtlagen eine Dicke von 0,5 bis 3 µm und die reinen Nitrid- oder Karbonitrid-Schichten Dicken von 0,1 bis 1 µm aufweisen.

In der DE 102 22 347 wird eine über ein CVD-Verfahren hergestellte TiBN-Schicht mit einem Bor-Gehalt von größer oder gleich 6 Gew.% beschrieben.

Die EP 1 365 045 beschreibt ein mittels CVD-Verfahren hergestellte TiBN-Schicht mit einem Bor-Gehalt von größer oder gleich 6 At.%.

In den Beispielen ist eine Multilagen-Deckschicht beschrieben, die eine Dicke von etwa 6 µm aufweist. Sie besteht aus ungefähr 30 Lagen, wobei sich auf einer vergleichsweise dünnen TiN-Lage eine jeweils etwa drei- bis fünfmal so dicke TiBN-Lage befindet. Die TiBN-Lagen sind vorzugsweise Mischphasenlagen aus TiN und TiB₂. 50 % bis 60 % der Mischphase liegen als Titandiborid (TiB₂) vor. Die TiN-Lagen sind untereinander vorzugsweise gleich dick. Ebenso sind die TiBN-Lagen vorzugsweise gleich dick.

Die Gebrauchsmusterschrift AT 0080346 U1 offenbart mehrlagige Hartstoffschichten, in denen undotierte mit Silizium-, Vanadium- oder Bor dotierte Nitridschichten (Ti Al Ta)N alternieren.

Aus den Publikationen zum Stand der Technik kann zusammenfassend geschlossen werden, dass die Zugabe von Bor deutlich die Härte erhöht. Die Verschleißbeständigkeit wird umso effektiver verbessert, je höher der Bor-Gehalt und desto größer die Schichtdicke sind. Limitierend für die obere Grenze des Bor-Gehalts ist im Besonderen das Auftreten von Borid-Bildung im Substratwerkstoff, was mit einer Versprödung im Bereich der Grenzfläche verbunden ist. Im Stand der Technik verwendet man daher vergleichsweise dicke B-haltige Hartstoffschichten, die sich alternierend mit Bor-freien Hartstoffschichten abwechseln können. Die Bor-freien Hartstoffschichten wirken hier als Diffusionssperrschichten.

Ein hoher Bor-Gehalt verstärkt nicht nur die Gefahr der Versprödung, sondern kann auch im Besonderen bei Verwendung als Schneidwerkzeug, und hier wiederum für die Bearbeitung von Stählen, zu einer Reaktion des Bors mit Eisen führen.

Resultierend aus den Nachteilen aus dem Stand der Technik und dem ständigen Bestreben die Lebensdauer von Werkzeugen zu verlängern und damit zu einer höheren Produktivität der Werkzeuge beizutragen, besteht die Aufgabe der Erfindung in der Bereitstellung einer CVD-Schicht, die eine verbesserte Abrasionsbeständigkeit, bei gleichzeitig höchstmöglicher Zähigkeit und chemischer Beständigkeit, insbesondere bei höheren Anwendungstemperaturen, aufweist. Zudem soll sie günstige tribologische Eigenschaften besitzen.

Die Aufgabe wird durch die Merkmale der unabhängigen Ansprüche gelöst.

Die mehrlagige CVD-Schicht weist eine Dicke von 0,5 µm bis 16 µm auf.

Zumindest eine Schichtlage der CVD-Schicht besteht aus einer metallischen Hartstoffschicht X der Gruppe der Nitride, Karbide, Karbonitride, Karbooxynitride eines oder mehrerer Elemente der Gruppe bestehend aus Ti, Al, Hf und Zr mit einer Dicke von 10 bis 90 nm. Zumindest eine weitere Schichtlage besteht aus einer mit Bor dotierten metallischen Hartstoffschicht Y der Gruppe der Nitride, Karbide, Karbonitride, Karbooxynitride eines oder mehrerer Elemente der Gruppe bestehend aus Ti, Al, Hf und Zr, wobei der Bor-Gehalt 0,005 bis 5 At.% und die Dicke 10 bis 90 nm betragen. Zumindest eine Schichtlage X grenzt an eine Schichtlage Y. Durch Interdiffusion oder durch Gasreste beim Beschichtungsprozess kann sich zwischen X und Y eine Übergangszone ausbilden. Bevorzugt liegt die Dicke der Übergangszone bei kleiner 10 nm.

Bis dato ging man allgemein davon aus, dass nanostrukturierte Schichten mittels CVD-Verfahrenstechniken aufgrund der hohen Abscheidetemperaturen, und der damit verbundenen Diffusion nicht herstellbar sind.

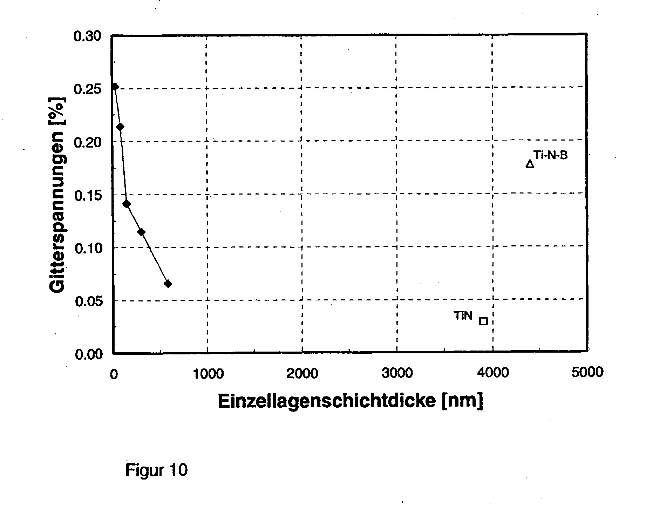

In überraschender Weise hat sich nun gezeigt, dass nanostrukturierte Schichten mittels thermischer CVD-Verfahren herstellbar sind. Die erfindungsgemäße Ausführung der X- und Y-Hartstoffschichten ergibt eine feinstkristalline Schichtstruktur, was wiederum eine sehr glatte Oberflächenstruktur zur Folge hat. Ein aufwändiges, nachträgliches Glätten der Oberfläche kann damit entfallen. Die X- und Y-Hartstoffschichten weisen dabei bevorzugt Vorzugsorientierungen in [111]- und [311]-Richtungen auf. Bei Dicken der Einzellagenschichten im erfinderischen Bereich übersteigen die Gitterspannungen der erfindungsgemäßen Multilagenschicht die einer Bor-haltigen Einzellagenschicht, wie dies in den Beispielen näher ausgeführt ist (siehe auch Figur 10). Da die Gitterspannungen in einem direkt-proportionalen Zusammenhang mit der Schichthärte stehen, steigt mit zunehmender Gitterspannung auch die Verschleißbeständigkeit. Damit ist es möglich, den Bor-Gehalt in den Y-Schichtlagen unter 5 At.% zu halten. Damit werden die Nachteile eines hohen Bor-Gehaltes, nämlich Versprödung und Reaktion mit dem zu bearbeitenden Werkstoff, vermieden. Bei Bor-Gehalten unter 0,005 At.% wird kein ausreichender Effekt erzielt. Ein besonders vorteilhafter Bereich liegt bei 0,3 bis 3 At.%.

Die erfindungsgemäße Schicht zeigt insbesondere bei tribologischen Beanspruchungen, die mit hohen Krafteinwirkungen oder stoßartiger Belastung verbunden sind, wie dies beispielsweise bei Fräswerkzeugen der Fall ist, ausgeprägte Vorteile gegenüber dem Stand der Technik. Wie in den Beispielen ausgeführt konnte eine Verdoppelung der Standzeit erzielt werden. Dieses ausgezeichnete Verschleißverhalten ist dem geringen Bor-Gehalt, verbunden mit den hohen Gitterspannungen zuzuschreiben. Auch ein Langzeiteinsatz unter Bedingungen, die zu einer hohen Temperatur im Schneidkantenbereich führen, bewirkt keine Abnahme der Schichthärte. Es tritt daher überraschenderweise keine unzulässig hohe Interdiffusion, im Speziellen von Bor, zwischen den Y- und X-Schichtlagen auf. Die feinkörnige Struktur der einzelnen Schichtlagen führt zudem zu einer hohen Zähigkeit der Schicht, verbunden mit einer geringen Ausbruchsneigung der Schneidkanten.

Um durch eine Nanostrukturierung hohe Gitterspannungen zu erzielen, ist es vorteilhaft, wenn die CVD-Schicht zumindest 3 Schichtlagen der Hartstoffschicht X und 3 Schichtlagen der Hartstoffschicht Y umfasst. Weiters ist es dabei vorteilhaft, wenn die Schichtabfolge X, Y, X, Y, X ist und sich die Abfolge X, Y zumindest 5x wiederholt. Ausgezeichnete Ergebnisse konnten erzielt werden, wenn die Summe der Anzahl der Schichtlagen X, Y 10 bis 500, bevorzugt 50 bis 300 beträgt.

Der Bereich für die mittlere Schichtdicke der Schichtlagen X und Y beträgt 10 bis 90 nm. Unter 10 nm nimmt die Interdiffusion von Bor zu. Bei Schichtdicken über 90 nm nimmt die Gitterspannung ab. Der bevorzugte Bereich liegt bei 30 bis 70 nm. Ein besonders günstiger Struktureffekt kann erzielt werden, wenn die einzelnen Schichtlagen in etwa die gleiche Dicke aufweisen. Die mittlere Schichtdicke der Schichtlagen X weicht dabei bevorzugt um maximal 30 % von der mittleren Schichtdicke von Y ab.

Weiters ist es vorteilhaft, wenn zumindest eine Hartstoffschicht X die Zusammensetzung TiₐN_{b}, mit 0,4 < a < 0,6 und 0,4 < b < 0,6 aufweist.

TiN ist dabei einer der am längsten bekannten Hartstoffe für Beschichtungen von Werkzeugen. Werden bei der Abscheidung von TiN zusätzlich Bor-haltige Gase verwendet, beispielsweise BCl₃, so entsteht eine Schicht mit hoher Härte, aber geringer Zähigkeit und chemischer Beständigkeit gegen Eisenwerkstoffen. Bei der Bearbeitung von Stählen, verbunden mit höheren Bearbeitungstemperaturen, führt dies insbesondere zu einem hohen Kolkverschleiß. Mit dem erfindungsgemäßen Schichtaufbau ist es möglich, den Bor-Anteil in einem minimalen, aber gut wirksamen Bereich einzugrenzen.

Eine besonders vorteilhafte Ausgestaltung der Erfindung wird erreicht, wenn zumindest eine, bevorzugt alle Hartstoffschichten X die Zusammensetzung TiₐC_{b}N_{c}, mit 0,4 < a < 0,6; 0,05 < b < 0,45 und 0,05 < c < 0,45 aufweisen.

Bei einem Bor-Gehalt in der Y-Schichtlage von ca. 4 At.-% konnte in einem trocken durchgeführten Fräsversuch eine Verdoppelung der Lebensdauer des verwendeten Werkzeuges erzielt werden. Diese signifikante Standzeitverlängerung weist auch hier auf die hohen Zähigkeitsreserven der beim Fräsen auf Schläge beanspruchten Schicht hin. In einem Drehversuch konnten ebenfalls deutliche Standzeitverlängerungen gegenüber dem Stand der Technik sowohl bei trockener als auch bei nasser Bearbeitung erzielt werden, wie dies in den Beispielen ausgeführt ist. Ausschlaggebend dafür ist insbesondere die verbesserte Abrasionsbeständigkeit. Der Struktureffekt verliert dabei erst bei mittleren Schichtlagendicken unter 20 nm an Wirkung.

Weiters konnten ausgezeichnete Ergebnisse erzielt werden, wenn zumindest eine, bevorzugt alle Hartstoffschichten X die Zusammensetzung TiₐAl_{b}N_{c}, mit 0 ≤ a < 0,55; 0 < b < 0,55 und 0,4 < c < 0,6 aufweisen. Ti kann daher vollständig durch Al ersetzt werden. Die Grenzwerte für a und b ergeben sich dabei aus dem erforderlichen Gehalt für eine Nitridbildung. Es lassen sich auch metastabile Schichtsysteme herstellen, wobei der Aluminiumgehalt in einem weiten Bereich variieren kann, was zur Ausbildung unterschiedlicher nitridischer Phasen, wie fcc-TiN, fcc-AIN oder hcp-AIN führt. Bereits bei Bor-Gehalten in der Y-Schichtlage von 1,0 At.% konnte eine hervorragende Abrasionsbeständigkeit erzielt werden.

Auch die weitere Zugabe von Kohlenstoff führt zu besonders vorteilhaften Ausführungsformen, vorzugsweise bei TiₐAl_{b}C_{c}N_{d}, mit 0 ≤ a < 0,55; 0 < b < 0,55; 0,05 < c < 0,45 und 0,05 < d < 0,45. N kann dabei durch C ersetzt werden. Die Grenzwerte ergeben sich dabei wiederum aus den erforderlichen Gehalten für eine Nitrid- / Karbidbildung.

Auch mit Hartstoffschichten X, die eine Zusammensetzung HfₐN_{b}, mit 0,4 < a < 0,6 und 0,4 < b < 0,6 aufweisen, konnten ausgezeichnete Ergebnisse erreicht werden. Auch hier ergeben sich Grenzwerte aus dem erforderlichen Gehalt für eine Nitridbildung.

In analoger Weise zu den X-Schichtlagen ergeben sich die vorteilhaften Ausgestaltungen der Y-Lagen, mit dem Unterschied, dass diese jeweils einen Bor-Gehalt von 0,005 bis 5 At.% aufweisen. Somit ergibt das folgende vorteilhafte Zusammensetzungen der Y-Lagen:
o TiₐB_{b}N_{c}, mit 0,4 < a < 0,6; 0,00005 < b < 0,05 und 0,4 < c < 0,6
o TiₐB_{b}C_{c}N_{d}, mit 0,4 < a < 0,6; 0,00005 < b < 0,05; 0,05 < c < 0,45 und 0,05 < d < 0,45
o TiₐAl_{b}B_{c}N_{d}, mit 0 ≤ a < 0,55; 0 < b < 0,55; 0,00005 < c < 0,05 und 0,4 < d < 0,6
o TiₐAl_{b}B_{c}C_{d}Nₑ, mit 0 ≤ a < 0,55; 0 < b < 0,55; 0,00005 < c < 0,05; 0,05 < d < 0,45 und 0,05 < e < 0,45
o HfₐB_{b}N_{c}, mit 0,4 < a < 0,6; 0,00005 < b < 0,05; 0,4 < c < 0,6.

Weiters kann es prozesstechnisch vorteilhaft sein, eine Schichtlage X mit der entsprechenden Bor-dotierten Y-Lage zu kombinieren. Entsprechend heißt in diesem Zusammenhang, dass mit Ausnahme des Bors die Komponenten der Y-Schichtlage auch in der X-Lage zu finden sind.

Eine weitere Erhöhung der Gitterverspannung kann erzielt werden, wenn zumindest zwei Schichtlagen der Hartstoffschicht X eine unterschiedliche Zusammensetzung X₁, X₂ und/oder zwei Schichtlagen der Hartstoffschicht Y eine unterschiedliche Zusammensetzung Y₁, Y₂ aufweisen. Beispielhaft ergeben sich damit Schichtabfolgen X₁, X₂, Y, X₁, X₂, Y, X₁, X₂ oder X, Y₁, Y₂, X, Y₁, Y₂, X, Y₁, Y₂,....

In den Hartstoffschichten X und/oder Y können verfahrensbedingte Mindestmengen an Sauerstoff und Chlor vorliegen. Dies ist insbesondere dann der Fall, wenn zur Erzielung einer tieferen Abscheidetemperatur im Bereich von 500 bis 700 °C reaktive Prozessgase verwendet werden. Dadurch ist es möglich, dass weitere Elemente, wie etwa Chlor- oder Sauerstoffatome, im Prozentbereich in der Schicht eingebaut sind. Durch eine in-situ oder nachgelagerte thermische Behandlung kann eine Reduktion der Chloratome sowie Umlagerungsreaktionen erzielt werden. Dies verbessert das Eigenschaftsprofil der Beschichtungen.

Die Hartstoffschicht X und/oder Y weist bevorzugt eine Struktur mit zwei oder mehreren kristallinen Phasenbestandteilen auf. Auch geringe Mengen an röntgenamorphen Gefügebestandteilen können vorhanden sein.

Die Schicht wird bevorzugt auf Werkzeugen abgeschieden, wobei diese in Kombination mit den Substratwerkstoffen Hartmetall oder Cermet - Werkstoffen die besten Eigenschaften aufweist. Dabei ist es günstig, wenn die mit dem Hartmetall oder Cermet in Kontakt stehende erste Schichtlage Titannitrid oder ein Titankarbonitrid ist. Als oberste Schichtlage (Decklage) bewährt sich besonders ein- oder mehrlagiges Aluminiumoxid mit einer Schichtdicke von 2 bis 8 µm, welche fallweise mit einer dekorativen Decklage versehen werden und/oder einer mechanischen Behandlung unterzogen werden kann.

Bevorzugt lassen sich die erfindungsgemäßen Schichten durch folgenden Verfahrensablauf herstellen.

Die Herstellung der erfindungsgemäßen Beschichtungen erfolgt in einer CVD-Beschichtungsanlage, welche bevorzugt mit den charakteristischen Merkmalen einer Computer-gesteuerten Prozessführung und Prozessgassteuerung ausgestattet ist. Die für die Prozessführung notwendigen Gase werden bevorzugt über Mass-Flow-Controller (MFCs) dosiert und in für die Erfindung erforderlichen zeitlichen Abfolge (Taktzeiten) gepulst in eine Gasmischeinheit eingeleitet, worin ein homogenes Gasgemisch erzeugt wird, das in weiterer Folge in einer integrierten Vorwärmekammer für den Beschichtungsprozess auf Reaktionstemperatur gebracht wird. Um die erfindungsgemäßen Dicken der X- und Y-Lagen zu erzielen, betragen die Taktzeiten je nach Reaktionsgaszusammensetzung (siehe auch Beispiele) bevorzugt zwischen 5 s bis 200 s. Zur Schichtabscheidung werden die Reaktionsgase in den für den Beschichtungsprozess vorbereiteten Reaktor eingeleitet. Die Vorbereitung des Beschichtungsreaktors umfasst eine Evakuierung des Reaktionsraumes mit den darin gelagerten Substratmaterialien und eine anschließende Erwärmung auf Beschichtungstemperatur unter Schutzgasatmosphäre.

Der CVD-Reaktor ist bevorzugt ein auf dem Heißwand-Prinzip arbeitendes offenes System mit mehreren temperatursteuerbaren Segmenten, in dem die Reaktionsgase auf unterschiedlichen Flussrichtungen und Flusswegen sowohl vertikal als auch radial den Reaktionsraum, in dem sich das zu beschichtende Stückgut befindet, durchströmen. Die Prozessführung kann sowohl bei Atmosphärendruck als auch im Unterdruck erfolgen. Die verbrauchten Prozessgase werden in einem geeigneten Gasreinigungssystem nachbehandelt. Am Ende des Beschichtungsprozesses erfolgt die Abkühlung unter Schutzgas. Es kann wahlweise eine thermische Nachbehandlung der Beschichtungen durch eine gezielte Gas- und Temperaturführung durchgeführt werden.

Im Folgenden wird die Erfindung durch Herstellbeispiele näher erläutert.

Tabelle 1 gibt die Zusammensetzung des Prozessgases wieder.

Tabelle 2 gibt die Ergebnisse der Verschleißtests / Proben 1 bis 3 wieder.

Tabelle 3 gibt die Ergebnisse der Verschleißtests / Proben 6 bis 8 wieder.
Figur 1 zeigt eine REM Aufnahme der Oberfläche von Probe 1 (erfindungsgemäß).
Figur 2 zeigt eine REM Aufnahme der Bruchfläche von Probe 1 (erfindungsgemäß).
Figur 3 zeigt eine REM Aufnahme der Oberfläche von Probe 2 (Stand der Technik).
Figur 4 zeigt eine REM Aufnahme der Bruchfläche von Probe 2 (Stand der Technik).
Figur 5 zeigt eine REM Aufnahme der Oberfläche von Probe 3 (Stand der Technik).
Figur 6 zeigt eine REM Aufnahme der Bruchfläche von Probe 3 (Stand der Technik).
Figur 7 zeigt die Ergebnisse des Verschleißtests gemäß Beispiel 2.
Figur 8 zeigt die Ergebnisse des Frästests gemäß Beispiel 3.
Figur 9 zeigt die Ergebnisse des Drehtests gemäß Beispiel 4.
Figur 10 zeigt die Gitterspannungen als Funktion der Einzellagenschichtdicke.

Die offenen Symbole stellen dabei die Gitterspannungen in einer Einlagenschicht, die geschlossenen Symbole die Gitterspannungen in einer Viellagenschicht dar. Auf der X-Achse ist die mittlere Schichtdicke der Einzellagen aufgetragen.

### Beispiel 1

Es wurde eine viellagige Beschichtung aus TiN (X-Lage) und TiNB (Y-Lage) (erfindungsgemäß, Probe 1) mit einer einlagigen Beschichtung aus TiN (Stand der Technik, Probe 2) und TiNB (Stand der Technik, Probe 3) verglichen, wobei die X- bzw. Y-Lagen der erfindungsgemäßen Schicht die gleiche Zusammensetzung wie die jeweilige Einlagenschicht aufwies.

Zu diesem Zweck wurden polierte Ronden, geeignet für einen tribologischen Test mittels Ball-on-Disc-Anordnung, aus einem handelsüblichen, feinkörnigen Hartmetall mit einer Zusammensetzung aus WC - 10 Gew.% Co beschichtet. Die Herstellung der erfindungsgemäßen mehrlagigen TiN- und TiNB Beschichtung erfolgte in einer produktionstauglichen CVD-Beschichtungsanlage entsprechend der Beschreibung.

Die mittlere Abscheidetemperatur der Schicht betrug 900°C. Die Prozessgaszusammensetzung (p = 1 bar) ist aus Tabelle 1 zu entnehmen. Die Herstellung der Viellagenschicht erfolgte durch gepulstes Umschalten der in Tabelle 1 angeführten Gaszusammensetzungen. Die Pulsdauer betrug 60 s. Die sich daraus ergebende mittlere Dicke der Schichtlagen X und Y betrug ca. 40 nm, welche durch TEM/EELS verifiziert wurde. X und Y wechselten sich alternierend ab, wobei die Gesamtschichtdicke 4,1 µm bis 5 µm betrug.

Die Phasenbestimmung und die Schichtstrukturkenngrößen wie Gitterspannungen wurde durch Linien-Profil-Analyse mittels XRD bestimmt. Die chemische Schichtzusammensetzung wurde mit quantitativer GDOES und EPMA an den jeweils einlagig aufgebrachten Schichten ermittelt. In der TiNB Schicht wurde ein Bor-Gehalt von 4 At% ermittelt.

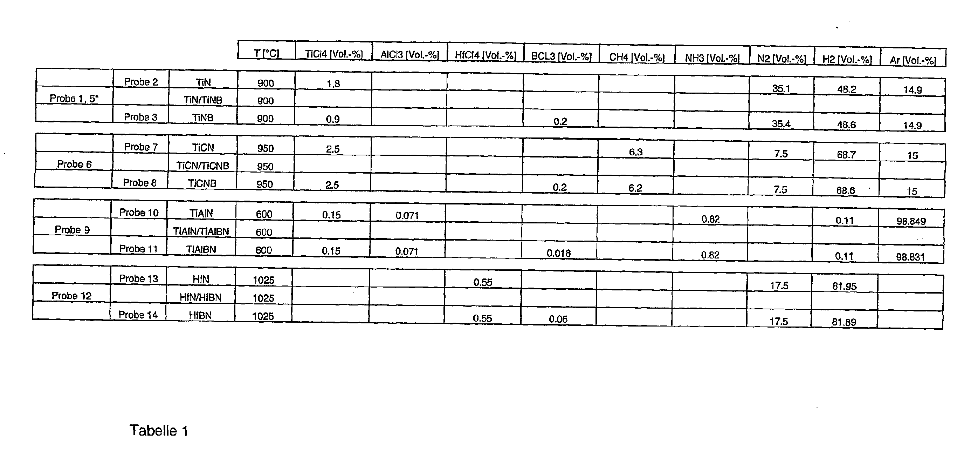

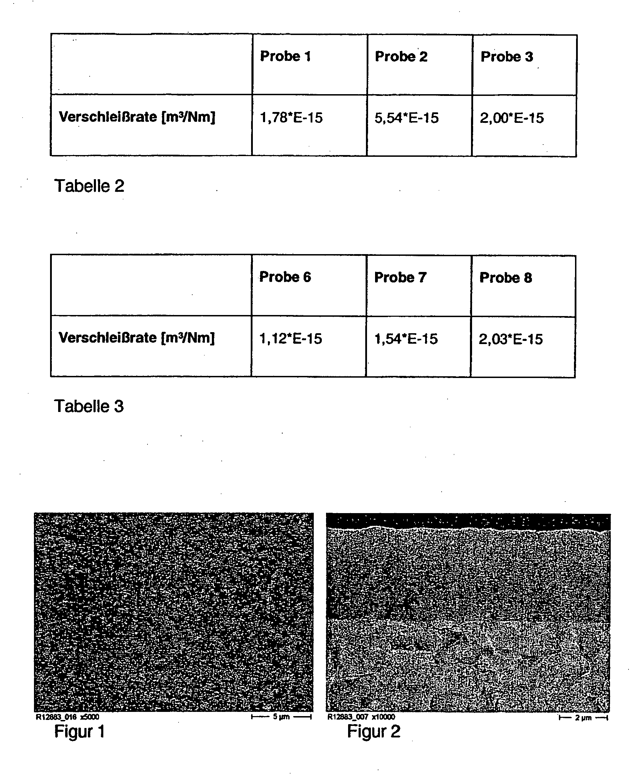

Die zu den Proben 1 bis 3 gemachten Strukturbilder der Oberflächen und der Bruchflächen sind in Figur 1 bis Figur 6 gezeigt. Die erfindungsgemäße Probe 1 zeigt eine besonders feine Bruchstruktur, mit einhergehender besonders glatter Oberfläche.

Die Proben 1 bis 3 wurden für eine vergleichende Untersuchung der Abrasionsbeständigkeit einem Ball-on-Disc-Verschleißtest unterzogen. Der Gegenkörper war dabei eine Al₂O₃ Kugel mit einem Durchmesser von 6 mm, welche in einem Radius von 7 mm in der Reibspur geführt wurde. Der Versuch wurde mit einer Anpresskraft von 5 N bei Raumtemperatur durchgeführt. Der Gleitweg betrug 700 m. Die Beschichtungen wurden im Rahmen der Testversuche nicht durchgerieben. In diesem quantitativen Verschleißtest zeigte sich anhand der resultierenden Verschleißrate (Tabelle 2) die überlegene Verschleißbeständigkeit der erfindungsgemäßen Probe 1 im Vergleich zum Stand der Technik.

Mit den Herstellparametern wie oben beschrieben, wurden TiN/TiNB Multilagenschichten abgeschieden. Durch Variation der Pulszeiten zur Änderung der Gaszusammensetzung wurden unterschiedliche Dicken der Schichtlagen erzeugt. Die mittleren Schichtdicken können Figur 10 entnommen werden. Von diesen Schichten und von TiN sowie TiNB Einlagenschichten wurden die Gitterspannungen wie oben beschrieben bestimmt. Bei einer mittleren Dicke der Schichtlagen von kleiner 90 nm sind die Gitterspannungen höher, als in einer Einlagen TiNB Schicht (siehe Figur 10).

### Beispiel 2

Eine Wendeschneidplatte wurde mit einer 3-lagigen Schicht aus jeweils ca. 1 µm dickem TiC (benachbart zum Hartmetall), TiCN und TiN (außen) gemäß dem Stand der Technik beschichtet (Probe 4). Bei der erfindungsgemäßen Probe wurde die TiN-Schicht durch eine erfindungsgemäße Viellagenschicht aus (TiN/TiNB)ₘₗ substituiert (Probe 5).

Die Substrate bildeten dabei Wendeschneidplatten des Typs SEKN 1203 AFSN aus einem handelsüblichen Hartmetall aus WC mit 9 Gew.% Co und 4 Gew.% TaC/NbC.

Die Herstellung der erfindungsgemäßen äußeren TiN (X-Lage) /TiNB (Y-Lage) Viellagenschicht erfolgte ebenfalls in einer produktionstauglichen CVD-Beschichtungsanlage wie oben beschrieben. Die mittlere Beschichtungstemperatur betrug dabei 900°C.

Die Prozessatmosphäre ist in Tabelle 1 abgebildet. Der Prozessdruck betrug 1 bar. Die Herstellung der Viellagenschicht erfolgt durch gepulstes Umschalten der in Tabelle 1 angeführten Gaszusammensetzungen. Die Pulsdauer betrug 60 s. Die hergestellten Schichten wiesen eine Gesamtschichtdicken von ca. 2,8 µm auf, wobei die erfindungsgemäße äußere Viellagenschicht eine Dicke von 1 µm aufwies. Die mittlere Dicke der Einzellagen X und Y betrug ca. 35 nm. Die Schichtkenndaten wurden entsprechend der Beschreibung in Beispiel 1 ermittelt.

Die Proben 4 und 5 wurden einem Zerspanungsversuch unterzogen, wobei folgende Bedingungen Verwendung fanden. Auf einer Ex-Cell-O-Fräsmaschine wurde ein 42CrMo4 Stahl (1.7225) (Festigkeit 1100 MPa) trocken mit einer Schnittgeschwindigkeit von v_{c} = 150 m/min, einem Vorschub pro Zahn von f_{z} = 0,15 mm und einer Zustellung aₚ = 2,0 mm im Einzahnverfahren im Gleichlauf zerspant. Das Abbruchkriterium für die Zerspanungsversuche wurde mit 0,3 mm Verschleißbreite an der Freifläche der Hauptschneide festgelegt.

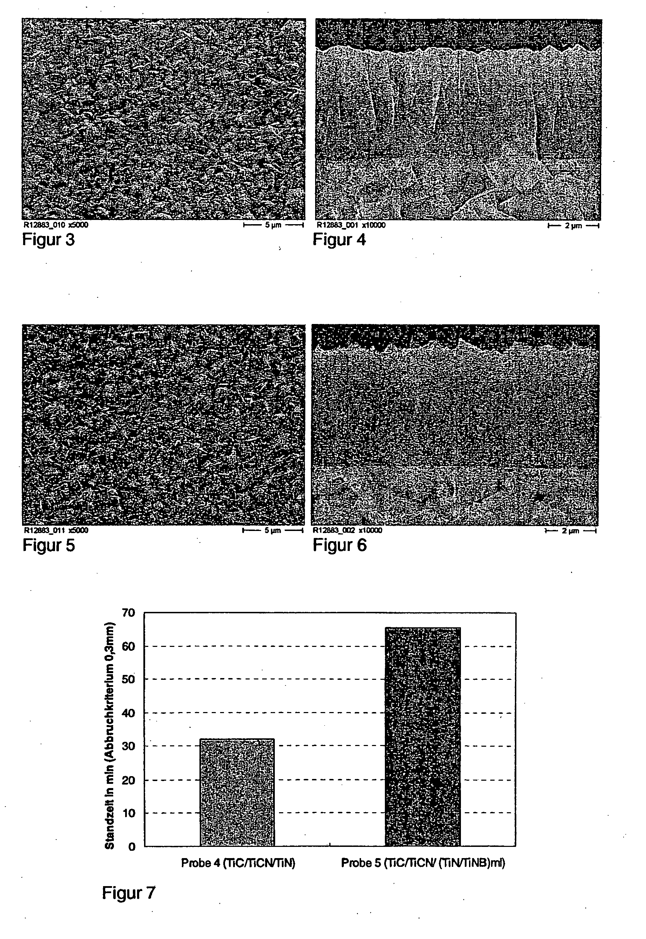

In diesem quantitativen Zerspanungstest zeigt sich (Figur 7) die überlegene Verschleißbeständigkeit der Probe 5 im Vergleich zu Probe 4. Mit einem Abbruchkriterium des Schnittversuches von 0,3 mm Freiflächenverschleiß zeigt die erfindungsgemäß modifizierte Probe 5 im Vergleich zu Probe 4 eine Verdoppelung der Standzeit.

### Beispiel 3

Es wurde eine erfindungsgemäße Beschichtung mit alternierenden TiCN (X-Lage) und TiCNB Lagen (Y) (Probe 6) mit jeweils einer einlagigen TiCN (Stand der Technik, Probe 7) und TiCNB (Stand der Technik, Probe 8) Beschichtung der gleichen Zusammensetzung wie in der entsprechende Lage der Viellagenschicht verglichen. Zu diesem Zweck wurden polierte Ronden aus einem handelsüblichen feinkörnigen Hartmetall mit einer Zusammensetzung aus WC mit 10 Gew.% Co als Substratwerkstoff verwendet. Die Herstellung der Beschichtungen erfolgte wiederum in beschriebener Vorgangsweise. Die Beschichtungstemperatur betrug 950°C. Die Prozessatmosphäre (p = 1 bar) ist der Tabelle 1 zu entnehmen. Die Herstellung der Viellagenschicht erfolgt durch gepulstes Umschalten der angeführten Gaszusammensetzungen. Die Pulsdauer betrug 60 s. Die Gesamtschichtdicke betrug um 3,5 µm, bei einer mittleren Dicke der TiCN (X-) und TiCNB (Y-) Lagen von 30 nm, welche nach den beschriebenen Verfahren in Beispiel 1 charakterisiert wurde. In der Y-Lage wurde ein Borgehalt von 3,5 At-% ermittelt.

Die erfindungsgemäße Probe 6 zeigte eine besonders glatte Oberfläche, die mit einer feinen Bruchstruktur einhergeht. Die Proben 6 bis 8 wurden wiederum einem tribologischen Verschleißuntersuchung mit dem Ball-on-Disc-Testgerät unterzogen, wobei gleiche Bedingungen wie in Beispiel 1 zur Anwendung kamen. In Tabelle 3 sind die Ergebnisse wiedergegeben. Es zeigte sich wiederum die weitaus höhere Verschleißbeständigkeit der erfindungsgemäßen Probe im Vergleich zum Stand der Technik.

### Beispiel 4

Zur Bestimmung der Verschleißbeständigkeit wurden auf Wendeschneidplatten für Dreh- und Fräsoperationen die in Beispiel 3 beschriebenen Schichten abgeschieden. Die Probenbezeichnungen entsprechen dem Beispiel 3.

Die Substrate bildeten dabei für die Frästests Wendeschneidplatten des Typs SEKN 1203 AFSN aus einem handelsüblichen Hartmetall aus WC mit 9 Gew.% Co und 4 Gew.% TaC/NbC. Für die Drehtests wurden Wendeschneidplatten des Typs CNMG 120408 EN-TM aus einem handelsüblichen Hartmetall mit einer Zusammensetzung aus WC mit 7 Gew.% Co und 8,1 Gew.% Mischkarbiden verwendet.

Die Herstellung der Beschichtungen erfolgte wie in Beispiel 3 beschrieben.

Für den Zerspanungsversuch fanden folgende Bedingungen Verwendung.

Auf einer Ex-Cell-O-Fräsmaschine wurde ein 42CrMo4 Stahl (1.7225) (Festigkeit 1100 MPa) trocken mit einer Schnittgeschwindigkeit von v_{c} = 150 m/min, einem Vorschub pro Zahn von f_{z} = 0,15 mm und einer Zustellung aₚ = 2,0 mm im Einzahnverfahren im Gleichlauf zerspant. Das Abbruchkriterium für die Zerspanungsversuche wurde mit 0,3 mm Verschleißbreite an der Freifläche der Hauptschneide festgelegt.

Auf einer Drehmaschine wurde ein Ck60 Stahl (1.1221) mit dem Wendeschneidplattentyp CNMG 120408 EN-TM mit einer Schnittgeschwindigkeit v_{c} = 200 m/min, einem Vorschub von f_{z} = 0,25 mm und einer Zustellung aₚ = 2,0 mm sowohl trocken, als auch unter Anwendung von Kühlschmiermittel (nass) zerspant. Das Abbruchkriterium für die Drehversuche wurde mit 0,3 mm Verschleißbreite an der Freifläche festgelegt.

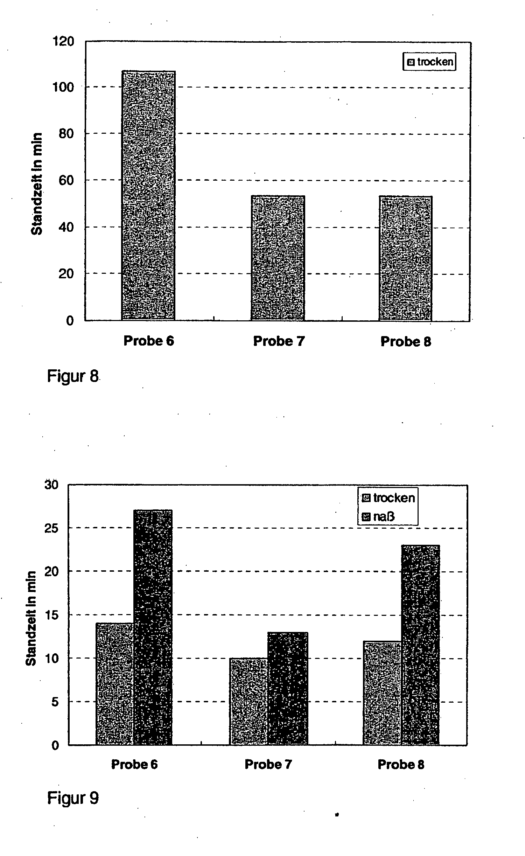

Im Frästest (Figur 8) konnte eine Verdoppelung der Standzeit der Probe 6 mit der erfindungsgemäßen Beschichtung im Vergleich zu den Proben 7 und 8 mit einlagigen Beschichtungen erzielt werden. Auch im Drehtest (Figur 9) zeigte Probe 6 mit der erfindungsgemäßen Beschichtung sowohl bei trockenen als auch bei nassen Zerspanungsbedingungen ein deutlich verbessertes Standzeitverhalten.

### Beispiel 5

Es wurde eine erfindungsgemäße viellagige Beschichtung (Probe 9) aus TiAlN (X-Lage) und TiAlNB (Y-Lage) mit einer einlagigen Beschichtung aus TiAlN (Stand der Technik, Probe 10) und TiAlNB (Stand der Technik, Probe 11) verglichen, wobei die X- und Y-Lagen der erfindungsgemäßen Schicht die gleiche Zusammensetzung wie die jeweilige Einlagenschicht aufwies. Zu diesem Zweck wurden polierte Ronden, geeignet für einen tribologischen Test (Ball-on-Disc), aus einem handelsüblichen feinkörnigen Hartmetall mit einer Zusammensetzung aus WC mit 10 Gew.% Co beschichtet.

Die Herstellung der Beschichtungen erfolgte in einer CVD-Beschichtungsanlage nach obiger Beschreibung. Die mittlere Temperatur betrug 600°C. Die Prozessgaszusammensetzung (p = 1 bar) ist aus Tabelle 1 zu entnehmen. Die Herstellung der Viellagenschicht erfolgte durch gepulstes Umschalten der in Tabelle 1 angeführten Gaszusammensetzungen. Die Pulsdauer betrug ebenfalls 60 s. Die Dicke der Einzelschichtlagen X und Y betrug ca. 50 nm. Die Charakterisierung der Schichten erfolgte analog zu Beispiel 1. Der Borgehalt in der Y-Lage betrug 1 At.%. Die Schichtlagen X und Y wechselten sich alternierend ab, wobei die Gesamtschichtdicke von 4,8 bis 6,7 µm betrug.

Die erfindungsgemäße Probe 9 zeigte wiederum eine feine Bruchstruktur mit einhergehender glatter Oberfläche. Die Proben 9 bis 11 wurden zum Vergleich der Abrasionsbeständigkeit einer tribologischen Verschleißuntersuchung mit dem Ball-on-Disc-Testgerät unterzogen. Der Gegenkörper war wiederum eine Al₂O₃ Kugel mit einem Durchmesser von 6 mm, welche in einer konzentrischen Verschleißspur von 5 mm Radius bei Raumtemperatur mit einer Anpresskraft von 2 N durchgeführt wurde. Der Gleitweg betrug 100 m. Die Beschichtung der Probe 10 wurde durchgerieben. Die Beschichtung der Probe 11 zeigte einen beginnenden Verschleiß, hingegen zeigte die Probe 9 keinen auswertbaren Verschleiß.

### Beispiel 6

Es wurde eine erfindungsgemäße viellagige Beschichtung (Probe 12) aus HfN (X-Lage) und HfNB (Y-Lage) mit einer einlagigen Beschichtung aus HfN (Stand der Technik, Probe 13) und HfNB (Stand der Technik, Probe 14) verglichen, wobei die X- und Y-Lagen der erfindungsgemäßen Schicht die gleiche Zusammensetzung wie die jeweilige Einlagenschicht aufwies. Es wurden analog zu Beispielen 1, 3 und 5 Proben für tribologische Tests hergestellt. Die mittlere Beschichtungstemperatur betrug 1025°C. Die Prozessgaszusammensetzung (p = 0,4 bar) ist aus Tabelle 1 zu entnehmen. Die Herstellung der Viellagenschicht erfolgte durch gepulstes Umschalten der in Tabelle 1 angeführten Gaszusammensetzungen.

Die Pulsdauer betrug 180 s. Die Dicke der Einzelschichtlagen X und Y betrug um 25 nm und wurden analog zu Beispiel 1 charakterisiert. In der Y-Lage wurde ein Borgehalt von 1,3 At-% ermittelt. X und Y wechselten sich alternierend ab, wobei die Gesamtschichtdicke von 1,4 µm bis 1,9 µm betrug.

Die erfindungsgemäße Probe 12 zeigte eine besonders glatte, zartgelbe Oberfläche. Die Proben 12 bis 14 wurden für eine vergleichende Untersuchung der Abrasionsbeständigkeit einem Ball-on-Disc-Verschleißtest mit Prüfparametern entsprechend Beispiel 1 unterzogen.

Die Beschichtung der Probe 13 wurde im Rahmen des Testversuches durchgerieben. Probe 12 mit dem erfindungsgemäßen Schichtaufbau wies einen geringeren Verschleiß als Probe 14 auf.

## Patentansprüche

1. Mehrlagige CVD-Schicht mit einer Dicke von 0,5 µm bis 16 µm,
**dadurch gekennzeichnet,**
**dass** diese
■ zumindest eine Schichtlage aus einer metallischen Hartstoffschicht X der Gruppe der Nitride, Karbide, Karbonitride, Karbooxynitride eines oder mehrerer Elemente der Gruppe bestehend aus Ti, Al, Hf und Zr mit einer Dicke von 10 bis 90 nm und
■ zumindest eine Schichtlage aus einer mit Bor dotierten metallischen Hartstoffschicht Y der Gruppe der Nitride, Karbide, Karbonitride, Karbooxynitride eines oder mehrerer Elemente der Gruppe bestehend aus Ti, Al, Hf und Zr, wobei der Bor-Gehalt 0,005 bis 5 At.% und die Dicke 10 bis 90 nm betragen, umfasst;
■ wobei zumindest eine Schichtlage X an eine Schichtlage Y grenzt.

2. CVD-Schicht nach Anspruch 1, **dadurch gekennzeichnet, dass** zwischen der Schichtlage X und der Schichtlage Y eine Übergangszone mit einer Dicke kleiner 10 nm ausgebildet ist.

3. CVD-Schicht nach einem der Ansprüche 1 bis 2, **dadurch gekennzeichnet**, diese zumindest 3 Schichtlagen der Hartstoffschicht X und 3 Schichtlagen der Hartstoffschicht Y umfasst.

4. CVD-Schicht nach einem der Ansprüche 1 bis 3, **dadurch gekennzeichnet, dass** die Schichtabfolge X, Y, X, Y, X, ist und sich die Abfolge X, Y zumindest 5 x wiederholt.

5. CVD-Schicht nach einem der Ansprüche 1 bis 4, **dadurch gekennzeichnet, dass** die Summe der Anzahl der Schichtlagen X, Y 10 bis 500 beträgt.

6. CVD-Schicht nach Anspruch 5, **dadurch gekennzeichnet, dass** die Summe der Anzahl der Schichtlagen X, Y 50 bis 300 beträgt.

7. CVD-Schicht nach einem der Ansprüche 1 bis 6, **dadurch gekennzeichnet, dass** die mittlere Schichtdicke der Schichtlagen X und Y 30 bis 70 nm beträgt.

8. CVD-Schicht nach einem der Ansprüche 1 bis 7, **dadurch gekennzeichnet, dass** die mittlere Schichtdicke der Schichtlagen X um maximal 30 % von der mittleren Schichtdicke von Y abweicht.

9. CVD-Schicht nach einem der Ansprüche 1 bis 8, **dadurch gekennzeichnet, dass** die Hartstoffschicht X zumindest eine Zusammensetzung aus der Gruppe
TiₐN_{b}, mit 0,4 < a < 0,6 und 0,4 < b < 0,6;
TiₐC_{b}N_{c}, mit 0,4 < a < 0,6; 0,05 < b < 0,45 und 0,05 < c < 0,45;
TiₐAl_{b}N_{c}, mit 0 ≤ a < 0,55; 0 < b < 0,55 und 0,4 < c < 0,6;
TiₐAl_{b}C_{c}N_{d}, mit 0 ≤ a < 0,55; 0 < b < 0,55; 0,05 < c < 0,45 und 0,05 < d < 0,45;
HfₐN_{b}, mit 0,4 < a < 0,6 und 0,4 < b < 0,6 aufweist.

10. CVD-Schicht nach einem der Ansprüche 1 bis 9, **dadurch gekennzeichnet, dass** die Hartstoffschicht Y zumindest eine Zusammensetzung aus der Gruppe
TiₐB_{b}N_{c}, mit 0,4 < a < 0,6; 0,00005 < b < 0,05 und 0,4 < c < 0,6;
TiₐB_{b}C_{c}N_{d}, mit 0,4 < a < 0,6; 0,00005 < b < 0,05; 0,05 < c < 0,45 und 0,05 < d < 0,45;
TiₐAl_{b}B_{c}N_{d}, mit 0 ≤ a < 0,55; 0 < b < 0,55; 0,00005 < c < 0,05 und 0,4 < d < 0,6;
TiₐAl_{b}B_{c}C_{d}Nₑ, mit 0 ≤ a < 0,55; 0 < b < 0,55; 0,00005 < c < 0,05; 0,05 < d < 0,45 und 0,05 < e < 0,45;
HfₐB_{b}N_{c}, mit 0,4 < a < 0,6; 0,00005 < b < 0,05; 0,4 < c < 0,6 aufweist.

11. CVD-Schicht nach einem der Ansprüche 1 bis 10, **dadurch gekennzeichnet, dass** der Bor-Gehalt in der Hartstoffschicht Y 0,3 bis 3 At.% beträgt.

12. CVD-Schicht nach einem der Ansprüche 1 bis 11, **dadurch gekennzeichnet, dass** in den Hartstoffschichten X und/oder Y verfahrensbedingte Mindestmengen an Sauerstoff und/oder Chlor vorliegen.

13. CVD-Schicht nach einem der Ansprüche 1 bis 12, **dadurch gekennzeichnet, dass** die Hartstoffschicht X und/oder Y zumindest teilweise eine Struktur mit zwei oder mehreren kristallinen Phasenbestandteilen aufweist.

14. CVD-Schicht nach einem der Ansprüche 1 bis 13, **dadurch gekennzeichnet, dass** in der Hartstoffschicht X und/oder Y geringe Mengen an röntgenamorphen Gefügebestandteilen vorhanden sind.

15. Werkzeug aus einem verschleißbeständigen Werkstoff, das mit einer mehrlagigen CVD-Schicht nach Patentanspruch 1 versehen ist.

16. Werkzeug nach Anspruch 15, **dadurch gekennzeichnet, dass** der verschleißbeständige Werkstoff Hartmetall oder Cermet ist.

17. Werkzeug nach Anspruch 15 oder 16, **dadurch gekennzeichnet, dass** die erste, dem verschleißbeständigen Werkstoff benachbarte Schichtlage Titannitrid oder Titankarbonitrid ist.

18. Werkzeug nach einem der Ansprüche 15 bis 17, **dadurch gekennzeichnet, dass** die oberste Schichtlage eine oxidische Schicht, bevorzugt Aluminiumoxid mit einer Schichtdicke von 2 bis 8 µm ist.

19. Werkzeug nach einem der Ansprüche 1 bis 18, **dadurch gekennzeichnet, dass** das Werkzeug ein Schneidwerkzeug ist.

20. Werkzeug nach Anspruch 19, **dadurch gekennzeichnet, dass** das Schneidwerkzeug eine Wendeschneidplatte ist.

## Claims

1. A multilayer CVD coating having a thickness of from 0.5 µm to 16 µm, **characterized in that** it comprises
■ at least one layer composed of a metallic hard material layer X from the group consisting of nitrides, carbides, carbonitrides, carbooxynitrides of one or more elements of the group consisting of Ti, Al, Hf and Zr having a thickness of from 10 to 90 nm and
■ at least one layer composed of a boron-doped metallic hard material layer Y from the group consisting of nitrides, carbides, carbonitrides, carbooxynitrides of one or more elements of the group consisting of Ti, Al, Hf and Zr where the boron content is from 0.005 to 5 atom% and the thickness is from 10 to 90 nm;
■ where at least one layer X adjoins a layer Y.

2. The CVD coating as claimed in claim 1, **characterized in that** a transition zone having a thickness of less than 10 nm has been formed between the layer X and the layer Y.

3. The CVD coating as claimed in either claim 1 or 2, **characterized in that** it comprises at least three layers of the hard material layer X and three layers of the hard material layer Y.

4. The CVD coating as claimed in any of claims 1 to 3, **characterized in that** the layer sequence is X, Y, X, Y, X and the X, Y sequence is repeated at least 5 times.

5. The CVD coating as claimed in any of claims 1 to 4, **characterized in that** the total number of the layers X, Y is from 10 to 500.

6. The CVD coating as claimed in claim 5, **characterized in that** the total number of the layers X, Y is from 50 to 300.

7. The CVD coating as claimed in any of claims 1 to 6, **characterized in that** the average thickness of the layers X and Y is from 30 to 70 nm.

8. The CVD coating as claimed in any of claims 1 to 7, **characterized in that** the average thickness of the layers X deviates by not more than 30% from the average layer thickness of Y.

9. The CVD coating as claimed in any of claims 1 to 8, **characterized in that** the hard material layer X has at least one composition from the group consisting of
TiₐN_{b}, where 0.4 < a < 0.6 and 0.4 < b < 0.6;
TiₐC_{b}N_{c}, where 0.4 < a < 0.6; 0.05 < b < 0.45 and 0.05 < c < 0.45;
TiₐAl_{b}N_{c}, where 0 ≤ a < 0.55; 0 < b < 0.55 and 0.4 < c < 0.6;
TiₐAl_{b}C_{c}N_{d}, where 0 ≤ a < 0.55; 0 < b < 0.55; 0.05 < c < 0.45 and 0.05 < d < 0.45;
HfₐN_{b}, where 0.4 < a < 0.6 and 0.4 < b < 0.6.

10. The CVD coating as claimed in any of claims 1 to 9, **characterized in that** the hard material layer Y has at least one composition from the group consisting of
TiₐB_{b}N_{c}, where 0.4 < a < 0.6; 0.00005 < b < 0.05 and 0.4 < c < 0.6;
TiₐB_{b}C_{c}N_{d}, where 0.4 < a < 0.6; 0.00005 < b < 0.05; 0.05 < c < 0.45 and 0.05 < d < 0.45;
TiₐAl_{b}B_{c}N_{d}, where 0 ≤ a < 0.55; 0 < b < 0.55; 0.00005 < c < 0.05 and 0.4 < d < 0.6;
TiₐAl_{b}B_{c}C_{d}Nₑ, where 0 ≤ a < 0.55; 0 < b < 0.55; 0.00005 < c < 0.05; 0.05 < d < 0.45 and 0.05 < e < 0.45;
HfₐB_{b}N_{c}, where 0.4 < a < 0.6; 0.00005 < b < 0.05; 0.4 < c < 0.6.

11. The CVD coating as claimed in any of claims 1 to 10, **characterized in that** the boron content of the hard material layer Y is from 0.3 to 3 atom%.

12. The CVD coating as claimed in any of claims 1 to 11, **characterized in that** minor amounts of oxygen and/or chlorine due to the process are present in the hard material layers X and/or Y.

13. The CVD coating as claimed in any of claims 1 to 12, **characterized in that** the hard material layer X and/or Y at least partly has a structure having two or more crystalline phase constituents.

14. The CVD coating as claimed in any of claims 1 to 13, **characterized in that** small amounts of X-ray-amorphous constituents of the microstructure are present in the hard material layer X and/or Y.

15. A tool composed of a wear-resistant material which is provided with a multilayer CVD coating as claimed in claim 1.

16. The tool as claimed in claim 15, **characterized in that** the wear-resistant material is cemented carbide or cermet.

17. The tool as claimed in claim 15 or 16, **characterized in that** the first layer adjacent to the wear-resistant material is titanium nitride or titanium carbonitride.

18. The tool as claimed in any of claims 15 to 17, **characterized in that** the uppermost layer is an oxidic layer, preferably aluminum oxide, having a thickness of from 2 to 8 µm.

19. The tool as claimed in any of claims 1 to 18, **characterized in that** the tool is a cutting tool.

20. The tool as claimed in claim 19, **characterized in that** the cutting tool is an indexable insert.

## Revendications

1. Revêtement CVD multicouche possédant une épaisseur comprise entre 0,5 µm et 16 µm, **caractérisé en ce que** ledit revêtement inclut
- au moins une couche X en un matériau métallique dur du groupe des nitrures, carbures, carbonitrures, oxycarbonitrures de l'un ou de plusieurs éléments du groupe Ti, Al, Hf et Zr, possédant une épaisseur comprise entre 10 et 90 nm
- et au moins une couche Y en un matériau métallique dur, dopé au bore, du groupe des nitrures, carbures, carbonitrures, oxycarbonitrures de l'un ou de plusieurs éléments du groupe Ti, Al, Hf et Zr, la teneur en bore étant comprise entre 0,005 et 5 At.% et l'épaisseur entre 10 et 90 nm,
tandis qu'au moins une couche X est adjacente à une couche Y.

2. Revêtement CVD selon la revendication 1, **caractérisé par** la présence, entre la couche X et la couche Y, d'une zone de transition d'une épaisseur inférieure à 10 nm.

3. Revêtement CVD selon la revendication 1 ou 2, **caractérisé en ce que** ledit revêtement inclut au moins 3 couches de matériau dur X et 3 couches de matériau dur Y.

4. Revêtement CVD selon l'une quelconque des revendications 1 à 3, **caractérisé en ce que** les couches se suivent selon le schéma X, Y, X, Y, X et **en ce que** la séquence X, Y se répète au moins 5 fois.

5. Revêtement CVD selon l'une quelconque des revendications 1 à 4, **caractérisé en ce que** la somme des nombres de couches X, Y est comprise entre 10 et 500.

6. Revêtement CVD selon l'une quelconque des revendications 1 à 5, **caractérisé en ce que** la somme des nombres de couches X, Y est comprise entre 50 et 300.

7. Revêtement CVD selon l'une quelconque des revendications 1 à 6, **caractérisé en ce que** l'épaisseur moyenne des couches X et Y est comprise entre 30 et 70 nm.

8. Revêtement CVD selon l'une quelconque des revendications 1 à 7, **caractérisé en ce que** l'épaisseur moyenne des couches X diffère de 30 pourcent au maximum de l'épaisseur moyenne des couches Y.

9. Revêtement CVD selon l'une quelconque des revendications 1 à 8, **caractérisé en ce que** la couche de matériau dur X présente au moins une combinaison du groupe
TiₐN_{b}, dans laquelle 0,4 <a< 0,6 et 0,4 <b< 0,6 ;
TiₐC_{b}N_{c}, dans laquelle 0,4 <a< 0,6 ; 0,05 <b< 0,45 et 0,05 <c< 0,45 ;
TiₐAl_{b}N_{c}, dans laquelle 0 ≤a< 0,55 ; 0 <b< 0,55 et 0,4 <c<0,6;
TiₐAl_{b}C_{c}N_{d}, dans laquelle 0 ≤a< 0,55 ; 0 <b< 0,55 ; 0,05 <c< 0,45 et 0,05 <d< 0,45 ;
HfₐN_{b}, dans laquelle 0,4 <a< 0,6 et 0,4 <b< 0,6.

10. Revêtement CVD selon l'une quelconque des revendications 1 à 9, **caractérisé en ce que** la couche de matériau dur Y présente au moins une combinaison du groupe
TiₐB_{b}N_{c}, dans laquelle 0,4 <a< 0,6 ; 0,00005 <b< 0,05 et 0,4 <c< 0,6 ;
TiₐB_{b}C_{c}N_{d}, dans laquelle 0,4 <a< 0,6 ; 0,00005 <b< 0,05 ; 0,05 <c< 0,45 et 0,05 <d< 0,45 ;
TiₐAl_{b}B_{c}N_{d}, dans laquelle 0 ≤a< 0,55 ; 0 <b< 0,55 ; 0,00005 <c< 0,05 et 0,4 <d< 0,6 ;
TiₐAl_{b}B_{c}C_{d}Nₑ, dans laquelle 0 ≤a< 0,55 ; 0 <b< 0,55 ; 0,00005 <c< 0,05 ; 0,05 <d< 0,45 et 0,05 <e< 0,45 ;
HfₐB_{b}N_{c}, dans laquelle 0,4 <a< 0,6 ; 0,00005 <b< 0,05 et 0,4 <c< 0,6.

11. Revêtement CVD selon l'une quelconque des revendications 1 à 10, **caractérisé en ce que** la teneur en bore dans la couche de matériau dur Y est comprise entre 0,3 et 3 At.%.

12. Revêtement CVD selon l'une quelconque des revendications 1 à 11, **caractérisé par** la présence, dans les couches de matériaux durs X et/ou Y, de quantités minimales d'oxygène et/ou de chlore inhérentes au procédé.

13. Revêtement CVD selon l'une quelconque des revendications 1 à 12, **caractérisé en ce que** les couches de matériaux durs X et/ou Y présentent, au moins pour partie, une structure possédant deux ou une pluralité de constituants en phase cristalline.

14. Revêtement CVD selon l'une quelconque des revendications 1 à 12, **caractérisé par** la présence, dans les couches de matériaux durs X et/ou Y, de faibles quantités de constituants structurels amorphes aux rayons X.

15. Outil réalisé en un matériau résistant à l'usure et doté d'un revêtement CVD multicouche selon la revendication 1.

16. Outil selon la revendication 15, **caractérisé en ce que** le matériau résistant à l'usure est du métal dur ou du cermet.

17. Outil selon la revendication 15 ou 16, **caractérisé en ce que** la première couche, adjacente au matériau résistant à l'usure, est en nitrure de titane ou en carbonitrure de titane.

18. Outil selon l'une quelconque des revendications 15 ou 17, **caractérisé en ce que** la couche de surface est une couche d'oxydation, de préférence de l'oxyde d'aluminium, possédant une épaisseur comprise entre 2 et 8 µm.

19. Outil selon l'une quelconque des revendications 15 ou 18, **caractérisé en ce que** ledit outil est un outil de coupe.

20. Outil selon la revendication 19, **caractérisé en ce que** l'outil de coupe est une plaquette amovible.
